# EUROPEAN PATENT APPLICATION

(11) **EP 1 505 400 A1**
(43) Date of publication of application: **09.02.2005**
(21) Application number: 03291983.9
(22) Date of filing: 07.08.2003
(51) Int. Cl.: G01R 31/3185

(54) **Scan capture frequency modulator**

(71) Applicant: Texas Instruments Incorporated, Dallas, Texas 75251 (US); Texas Instruments France, 06271 Villeneuve Loubet Cedex, Nice (FR)
(72) Inventor: Paglieri, Alessandro, 18032 Sussana di Sanremo (IT)
(74) Representative: Holt, Michael

(57) **Abstract**

A circuit with a scan test architecture with multiple circuit blocks (12) having different frequency requirements uses scan capture frequency modulators (14) to vary the capture period for each circuit block (12). Each circuit block (12) is thus provided a scan capture period closest to the application speed of the functional circuitry (13a) of the particular block (12).

## Description

This invention relates in general to electronic circuit testing and, more particularly, to scan testing of electronic circuits.

As circuit designs become denser and more complicated, the need for testing increases. Scan path testing is a preferred method of testing electronic circuits. In scan path testing, test data from a serial path is input to various circuit modules and the resultant output captured by the serial path and compared to expected results.

In a typical electronic device, different functional circuit blocks are designed and optimized at different frequencies. Accordingly, once data is applied to the blocks, the time needed for the data to propagate through the circuitry and become stable (the "capture period") may be different from block to block. In order to avoid violations, the overall scan capture frequency must be set to that of the slowest block.

By setting the capture frequency to that of the slowest block, however, the scan capture frequency cannot be used as timing validation of the faster blocks. Multiple capture clocks could be used to vary the capture frequency for different circuit blocks; however, this would add significant cost to the test circuitry and test pattern generation.

Therefore, a need has arisen for a simple method and apparatus for providing multiple scan capture frequencies to various circuit blocks.

### BRIEF SUMMARY OF THE INVENTION

In the present invention, a scan test clock modulation circuit comprises circuitry for receiving a scan test clock signal and circuitry for selectively passing the scan test clock to one or more circuit blocks. The passing circuitry generates a desired interval between a first clock edge defining a start of a capture period and a second clock edge defining an end of the capture period.

The present invention provides significant advantages over the prior art. First, it allows circuitry blocks with different frequency requirements to be tested at application speed using a single scan test clock. Second, the scan capture frequency modulators can be provided with a small gate count.

### BRIEF DESCRIPTION OF THE SEVERAL VIEWS OF THE DRAWINGS

For a more complete understanding of the present invention, and the advantages thereof, reference is now made to the following descriptions taken in conjunction with the accompanying drawings, in which:
Figure 1 is a timing diagram illustrating a problem with present day scan testing;
Figure 2 illustrates a block diagram of a scan path test architecture that allows various circuit blocks to be tested at different speeds, while using a single scan test clock;
Figure 3 illustrate a schematic diagram of an scan capture frequency module; and
Figure 4 illustrates a timing diagram describing the operation of a scan capture frequency module for various speeds.

### DETAILED DESCRIPTION OF THE INVENTION

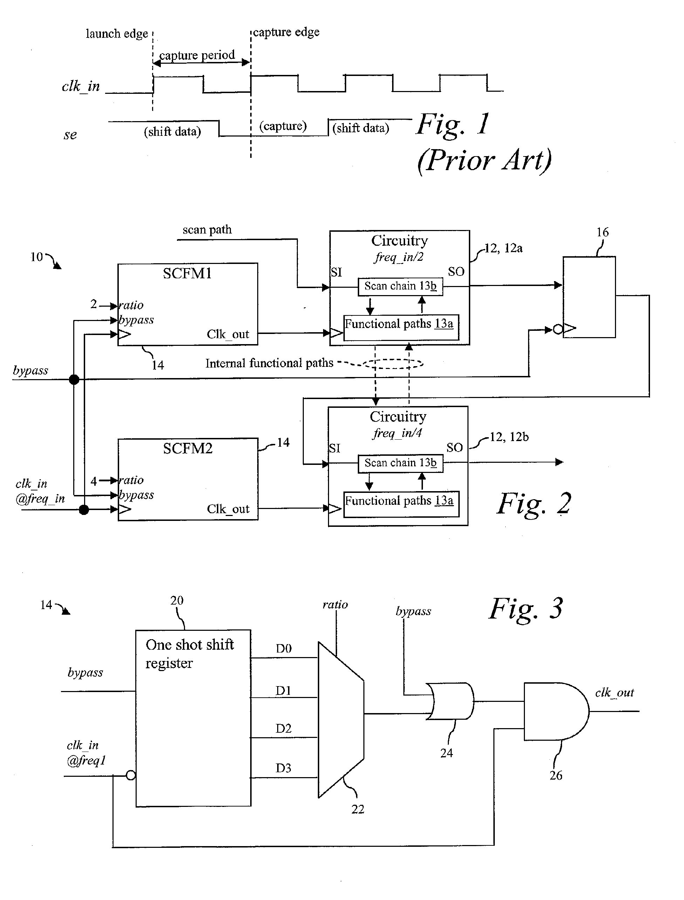

The present invention is best understood in relation to Figures 1 - 4 of the drawings, like numerals being used for like elements of the various drawings.

Figure 1 is a timing diagram illustrating a problem with present day scan testing. The scan test clock (clk_in) control the shifting of data along the scan path. Functional circuitry operates on data on the scan path. While the se (scan enable) control signal is high, data is shifted along the scan path without modification from the functional circuitry. While the se control signal is low, however, data is captured from the functional circuitry onto the scan path. The captured data can be shifted out for observation and comparison, or shifted to other functional circuitry.

Using present day systems, data passing through the functional circuitry must become stable in the time period defined by two consecutive active edges of the scan test clock in order to be properly captured by the second edge. The active edge prior to the se control signal entering capture mode is referred to as the "launch edge" and the active edge after the se control signal entering capture mode is referred to as the "capture edge".

Any data being captured under control of the scan test clock must therefore pass through the functional circuitry and become stable within the capture period. If the scan path is used over multiple circuit blocks, as is typical, all of the circuit blocks must be able to stabilize prior to the end of the capture period. Therefore, the scan test clock must be designed such that the slowest circuit block will stabilize prior to the end of the capture period.

Using a worst-case scan test clock, however, means that circuits designed to operate a speeds faster than the scan test clock cannot be tested at application speed. Figure 2 illustrates a block diagram of a scan path test architecture 10 that allows various circuit blocks to be tested at different speeds, while using a single scan test clock (clk_in) having a frequency of freq_in. Circuitry blocks 12 receive scan test data at a scan input SI and output scan test data at a scan output SO. As described above, when control signal se is low, the functional circuitry 13a of circuitry blocks 12 processes data at the inputs of the functional circuitry and on internal functional paths responsive to a capture clk_in pulse; when se is high, the test data is shifted from SI to SO through internal scan paths 13b. Figure 2 illustrates two circuitry blocks, a first circuitry block 12a having a designed operating speed of freq_in/2 and second circuitry block 12b having a designed operating speed of freq_in/4. In an actual circuit, any number of circuit blocks 12 with different operation speeds could be implemented.

The local scan clocks for the circuitry blocks 12 are generated from the scan test clock, clk_in, using respective scan capture frequency modulator circuits (SCFMs) 14. Each SCFM receives clk_in, a ratio control signal (ratio), and a bypass signal (bypass) generated by the scan test circuitry. The ratio fixes the capture period relative to clk_in. Hence, for a ratio of four, the capture period will be capture_period_in*4, where capture_period_in is the capture period associated with clk_in. Similarly, for a ratio of two, the capture ratio will be capture_period_in*2.

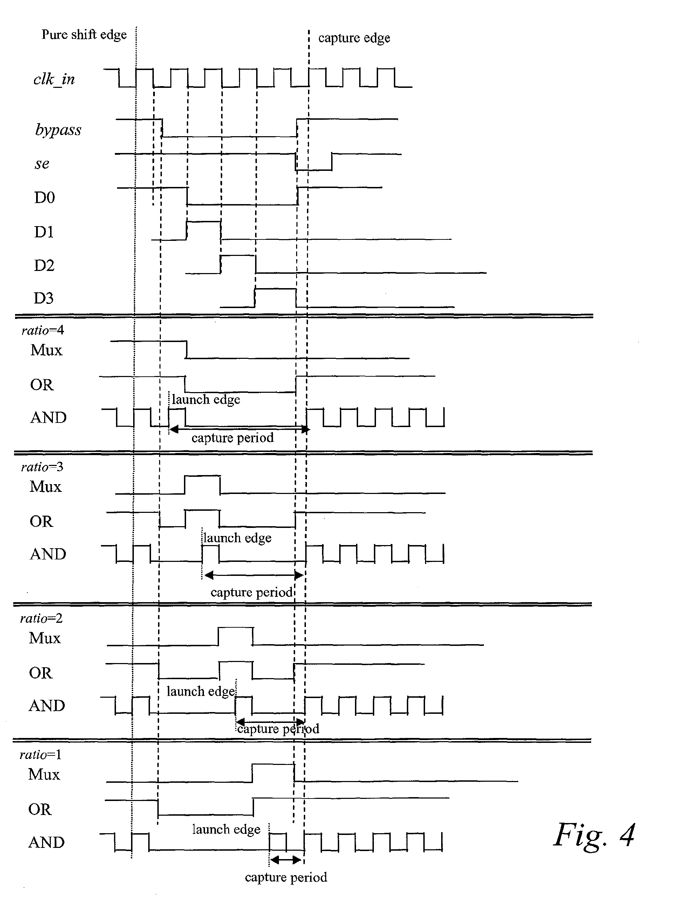

The bypass signal is used to control the SCFMs 14, as discussed in greater detail in connection with Figures 3 and 4. Latch 16 is used to hold data between circuitry blocks with different operating frequencies.

In operation, the SCFMs 14 pass clk_in to the circuitry blocks 12 until the launch edge is about to occur. During a capture, the time between the launch edge and the capture edge is elongated responsive to ratio. Once all circuit blocks 12 have launched the data from the functional circuitry 13a, the SCFMs 14 resume passing clk_in to the circuit blocks 12. The capture edge will occur synchronously for all of the circuit blocks 12.

Figure 3 illustrate a schematic diagram of an SCFM 14. The bypass control signal and clk_in are input to a one-shot shift register 20. The one-shot shift register 20 has multiple outputs (labeled D0, D1, D2 and D3) corresponding to valid values of ratio. In the embodiment illustrated in Figures 3 and 4, valid values for ratio would be 1, 2, 3 or 4. After a reset (initiated by a rising edge of bypass), the outputs D0-D3 are set to "1", "0", "0" and "0", respectively. Responsive to a falling edge of clk_in, the one shot shift register 20 will output pulses of having a duration of one clock period on the outputs D0-D3 at various delays. D0 will have a delay of zero (as shown in Figure 4), D1 will have a delay of 1*capture_period_in, D2 will have a delay of 2*capture_period_in, D3 will have a delay of 3*capture_period_in. At the end of the count, the one-shot shift register stabilizes on its overflow value until it is reset by a rising edge of bypass. The outputs D0-D3 are input to a multiplexer 22; the selected output of multiplexer 22 is controlled by ratio. The output of multiplexer 22 is coupled to one input of OR gate 24; the other input is coupled to bypass. The output of OR gate 24 is coupled to an input of AND gate 26; the other input of AND gate 26 is coupled to clk_in.

In operation, the OR gate 24 controls whether AND gate 26 will pass the clk_in signal or will pass a logical "0". While bypass is high, AND gate 26 passes clk_in regardless of the value of the output of the multiplexer 22. When bypass is low, the AND gate 26 passes clk_in only when the pulse passed through the multiplexer 22 is high.

Accordingly, a high bypass signal causes the SCFM circuitry to be bypassed (i.e., clk_in is passed to the circuitry blocks 12). A low bypass signal allows the launch pulse to be set according to one of a plurality of pulses from the one shot shift register, selected responsive to the value of ratio.

In the preferred embodiment, modulation of the capture period is attained by adjusting the launch edge, rather than the capture edge, since the launch edge is also the last shift edge. With se still active (high), no violation is possible between circuit blocks 12 with different frequency domains. Latch 16 is sufficient to avoid possible scan chain violations between circuit blocks having different frequencies.

The operation of the SCFM 14 is best understood in relation to the timing diagram of Figure 4. After the last "pure" shift clock pulse, the bypass signal transitions low after the next falling edge of clk_in. With bypass low, control of the AND gate 26 switches to the selected output of multiplexer 22. The next falling edge of clk_in (after a falling bypass) triggers the one shots. In the illustrated embodiment, the bypass signal remains low for four clock periods of clk_in, since the maximum value of ratio is four.

Figure 4 separately illustrates operation of the circuit with each of the SCFM for each possible value of ratio. For ratio=4, the output D0 is passed to the output of multiplexer 22. Since D0 is set to "1" on a reset, the launch/shift edge will be the first rising edge of clk_in after the pure shift edge. After the launch/shift edge, AND gate 26 will resume passing clk_in after bypass transitions high.

For ratio=3, the output D1 is passed to the output of multiplexer 22. Since D1 is set to "0" on a reset and transitions to a "1" on the second falling edge of clk_in after the pure shift edge (the first falling edge does not pass through the AND gate, since it is blocked by the bypass signal), the launch/shift edge will be the second rising edge of clk_in after the pure shift edge. Once again, after the capture edge, AND gate 26 will resume passing clk_in after bypass transitions high.

For ratio=2, the output D2 is passed to the output of multiplexer 22. Since D2 is set to "0" on a reset and transitions to a "1" on the third falling edge of clk_in after the pure shift edge, the launch/shift edge will be the third rising edge of clk_in after the pure shift edge. Once again, after the launch/shift edge, AND gate 26 will resume passing clk_in after bypass transitions high.

For ratio=1, the output D3 is passed to the output of multiplexer 22. Since D3 is set to "0" on a reset and transitions to a "1" on the fourth falling edge of clk_in after the pure shift edge, the launch/shift edge will be the fourth rising edge of clk_in after the pure shift edge. Once again, after the launch/shift edge, AND gate 26 will resume passing clk_in after bypass transitions high.

In an actual embodiment, it is possible to share SCFMs 14 between different circuit blocks 12 so long as the circuit blocks have the same operating frequency. In some cases, it may be preferable to have separate SCFMs for functionally distinct circuit blocks.

The ratio signal can be either fixed or variable. If variable, it could be configured by JTAG (Joint Test Access Group) TAP (Test Access Port) commands or directly by device level control inputs. A variable ratio signal would allow individual circuit blocks to be tested at different operating speeds. In an embodiment where ratio was a fixed, the multiplexer could be eliminated by connecting the appropriate output (D0-Dx) to the OR gate 24 for further savings in gate usage.

The present invention provides significant advantages over the prior art. First, it allows circuitry blocks with different frequency requirements to be tested at application speed using a single scan test clock. Second, the scan capture frequency modulators can be provided with a small gate count - on the order of 50 equivalent gates for up to four ratio values. Third, the scan capture frequency modulators can be easily expanded to any number of desired ratio values.

Although the Detailed Description of the invention has been directed to certain exemplary embodiments, various modifications of these embodiments, as well as alternative embodiments, will be suggested to those skilled in the art. The invention encompasses any modifications or alternative embodiments that fall within the scope of the Claims.

## Claims

1. A scan test clock modulation circuit comprising:
circuitry for receiving a scan test clock signal;
circuitry for selectively passing the scan test clock to one or more circuit blocks such to generate a desired interval between a first clock edge defining a start of a capture period and a second clock edge defining an end of the capture period.

2. The scan test clock of claim 1 wherein said passing circuitry comprises circuitry for selectively passing the first and second clock edges responsive to a control value indicating the desired interval.

3. The scan test clock of claim 1 wherein said passing circuitry comprises circuitry for selectively passing the first and second clock edges responsive to a bypass control signal indicating a time period in which the capture period must occur and a control value indicating the desired interval.

4. The scan test clock of claim 3 wherein said passing circuitry sets the second clock edge responsive to the bypass control signal and sets the first clock edge relative to the second clock edge responsive to the control value.

5. A circuit comprising:
scan test circuitry for carrying test data responsive to a scan test clock;
a plurality of circuit blocks each including:
scan test circuitry for carrying test data responsive to a scan test clock; and
functional circuits having varying operating frequencies coupled to said scan test circuitry, such that the functional circuits process the test data starting at a beginning of a capture period defined by a first clock edge of said scan test clock and said scan test circuitry stores processed data at an end of the capture period defined by a second clock edge of the scan test clock; and
a plurality of scan test modulation circuits, each coupled an associated set of one or more circuit blocks, for selectively passing the scan test clock to the circuit blocks to generate a capture period in each circuit block in accordance with the operating frequency of the circuit blocks.

6. The circuit of claim 5 wherein each scan test modulation circuit generates a capture period responsive to a control value.

7. The circuit of claim 6 wherein the control value for one or more of the scan test modulation circuits is fixed.

8. The circuit of claim 6 wherein the control value for one or more of the scan test modulation circuits is variable.

9. A method of testing a circuit, comprising the steps of:
shifting test data through circuit blocks responsive to a scan test clock;
selectively passing the scan test clock to the circuit blocks to provide capture periods at each circuit block responsive to an associated operating frequency of a functional circuit in each circuit block.

10. The method of claim 9 wherein said step of selectively passing the scan test clock comprises the steps of:
selectively passing first and second clock edges of the capture period responsive to a bypass control signal indicating a time period in which the capture period must occur and a control value indicating the desired interval.
